Europäisches Patentamt

European Patent Office

Office européen des brevets

(11) Veröffentlichungsnummer: **0 666 480 A1**

## (12) EUROPÄISCHE PATENTANMELDUNG
### veröffentlicht nach Art. 158 Abs. 3 EPÜ

(21) Anmeldenummer: **93924243.4**

(22) Anmeldetag: **19.10.93**

(86) Internationale Anmeldenummer:
**PCT/RU93/00236**

(87) Internationale Veröffentlichungsnummer:
**WO 94/09375 (28.04.94 94/10)**

(51) Int. Cl.6: **G01R 21/133**

(30) Priorität: **20.10.92 RU 9201253**

(43) Veröffentlichungstag der Anmeldung:
**09.08.95 Patentblatt 95/32**

(84) Benannte Vertragsstaaten:
**DE FR GB**

(71) Anmelder: **FIRMA "MERIDIAN"**
**ul. Nogradskaia, 3**
**Kemerovo, 650099 (RU)**

(72) Erfinder: **SAMOKISH, Viacheslav Vasilievich**
**pr. Kirova, 40-30**
**Tomsk, 634041 (RU)**

(74) Vertreter: **Ritter und Edler von Fischern,**
**Bernhard, Dipl.-Ing. et al**
**Hoffmann, Eitle & Partner,**
**Patentanwälte,**
**Arabellastrasse 4**
**D-81925 München (DE)**

(54) **LEISTUNGSFREOUENZWANDLER (SEINE VARIANTEN).**

(57) Die Erfindung betrifft die Elektromeßtechnik und ermöglicht die Lösung der Aufgabe der Leistungsumwandlung mit einem geringen relativen Fehler bei beliebiger Richtung der mittleren Leistung im Meßkreis.

Der Wandler entsprechend der ersten Variante enthält Modulformer für Strom 3 und Spannung 4. Die Betragskomponenten werden im Einquadrantenmultiplikator 6 multipliziert. Am Ausgang des zweiten steuerbaren Inverters 10 erfolgt die Wiederherstellung des Vorzeichens des Produktes der Momentanwerte der Eingangssignale. Der Niederfrequenzfilter 11 bildet das Analogsignal des Mittelwertes der Leistung nach der Zeit, deren Vorzeichen der zweite Komparator 12 fixiert. Der Integrator 8 verwirklicht die stetige Integration der Momentanleistung, wobei die Änderung seines Ausgangssignales durch die Breite der Hystereseschleife des Komparators 9 begrenzt wird, der den Zustand des ersten steuerbaren Inverters 7 durch das erste und dritte Logikelement EXKLUSIVES ODER 13 und 14 bestimmt. Die Frequenz des Impulssignales am Ausgang des Hysterese-Komparators 9 ist der Leistung im Meßkreis proportional. Bei Änderung ihrer Polarität geht die Arbeitsfähigkeit nicht verloren, da der zweite Komparator 12 durch das erste Logikelement EXKLUSIVES ODER 13 das Signal der Rückkopplung des Frequenzkanals invertiert.

Im Wandler entsprechend der zweiten Variante wird der logarithmische Multiplikator 6 eingesetzt sowie auch drei sperrbare Exponentialelemente 16, 17 und 18 eingeführt, die mit ihren Signaleingängen an den logarithmischen Ausgang des Multiplikators 6 angeschlossen sind und an ihren Ausgängen das Signal am Linearausgang des Multiplikators wiederholen.

FIG 1

Die Erfindung betrifft die Elektromeßtechnik und kann für Messungen der elektrischen Leistung und Energie des Wechsel- und Gleichstromes verwendet werden.

Die für die Messung der elektrischen Leistung und Energie, darunter auch in Elektroenergiezählern verwendbaren Leistungsfrequenzwandler sollen gleichzeitig die im folgenden genannten Hauptforderungen erfüllen:

- Aufweisen einer hohen Genauigkeit mit einem garantierten relativen Fehler bei der Elektroenergiemessung in einem breiten dynamischen Bereich (durch Überlastungsfähigkeit);
- Gewährleistung der Arbeitsfähigkeit bei beiden möglichen Richtungen des Leistungs- oder Energieflusses im Eingangskreis;
- Vorhandensein einer hohen Empfindlichkeit (niedrige Empfindlichkeitsschwelle);
- Ausschließen eines Fehlers beim Ausfall selbst einer der Eingangsgrößen Strom oder Spannung bei breitem Änderungsbereich der zweiten (Ausschließen der Erscheinung des Selbstlaufes in Zählern).

Bisheriger Stand der Technik

Es ist eine Einrichtung zur Messung der Leistung bekannt, die Eingangswandler für Strom und Spannung, einen logarithmischen Multiplikator, einen Strominverter und einen Niederfrequenzfilter enthält (siehe USA-Pat. N 4788494 MKI G 01 R 22/00, Anmeldung EPW N 0189754 MKI G 01 R 21/06). Der Nachteil dieser Einrichtung besteht im geringen Änderungsbereich der Meßgröße mit garantiertem Wert des relativen Fehlers, der für die Schaffung von Elektroenergiezählern auf ihrer Basis erforderlich ist.

Es ist auch eine Einrichtung zur Messung von Elektroenergie bekannt, die Eingangswandler für Strom und Spannung, einen Multiplikator, einen steuerbaren Inverter, einen Integrator, einen Komparator, ein Logikelement EXKLUSIVES ODER enthält (siehe britisches Pat. N 2197083 MKI G 01 R 21/06 veröffentl. 11.05.88). Die Nachteile der Einrichtung sind die Arbeitsunfähigkeit bei Richtungsänderung der mittleren Lastleistung sowie ihr kleiner Änderungsbereich mit garantiertem Wert des relativen Meßfehlers.

Größte Nähe bezüglich des technischen Wesens und der zu lösenden Aufgabe hat der digitale Wirkleistungswandler, der Eingangswandler für Strom und Spannung, deren Eingänge mit den entsprechenden Eingangsschienen und deren Ausgänge mit den Eingängen des ersten und des zweiten Modulformers (Modulgebers) verbunden sind, einen Multiplikator, dessen Eingänge an die Ausgänge des ersten und zweiten Modulformers angeschlossen sind, einen ersten und einen zweiten Komparator, deren Ausgänge mit den Eingängen des Logikelements EXKLUSIVES ODER verbunden sind, einen Inverter, einen Integrator enthält (siehe A.s. UdSSR N 1275308 MKI G 01 R 21/133 veröffentl. BI N 45, 1988). Dieser Wandler verwirklicht unabhängig vom Vorzeichen der Eingangssignale ihre Multiplikation in einem Quadranten, wodurch seine Genauigkeit nur durch die in diesem Quadranten auftretende Nichtlinearität beeinflußt wird.

Der Nachteil dieser Einrichtung besteht im geringen dynamischen Arbeitsbereich mit garantiertem relativen Wandlungsfehler ,was es z.B. nicht erlaubt, sie zur Schaffung von Elektroenergiezählern zu verwenden. Erstens wird der Anwendungsbereich des Wandlers auf elektrische Kreise mit nur einer Richtung (Polarität) der zu messenden Leistung begrenzt, wobei aber sogar in diesem Fall eine vorherige Phasenabstimmung der Eingangskreise notwendig ist. Bei Richtungsänderung der mittleren Leistung im Meßkreis aber stellt der Wandler seine Arbeit ein. Zweitens weist die in dieser Einrichtung bei der digitalen Leistungswandlung verwendete Realisierung der Zwischenumwandlung in die relative Impulsdauer prinzipiell einen begrenzten dynamischen Arbeitsbereich mit garantiertem relativen Wandlungsfehler auf, der gewöhnlich eine Dekade (dezimale Größenordnung) der Änderung des Ausgangsparameters nicht überschreitet. Das erklärt sich aus dem Vorhandensein von zusätzlichen Komponenten des Apparatefehlers bei der Wandlung in einen Zwischenparameter. Eine dieser Komponenten ist der Fehler der Nachbildung der Operation der Integration der Analogsignale im Integrator, dessen genaueste Realisierung in der Ladung eines Kondensators im negativen Rückkopplungskreis eines Operationsverstärkers besteht. Das Verhältnis der Parameter der Nichtidealität letzteren (Spannung und Versatzstrom) und des Nutzsignalpegels des Integrators entspricht faktisch der Größe des relativen Fehlers der Wandlung in die relative Impulsdauer und dementsprechend dem Wert des Digitalkodes am Ausgang des Wandlers. Eine andere Quelle des zusätzlichen Fehlers sind die Endlichkeit der Umschaltzeit der Schaltelemente und der Bestimmungszeit der Signale in der Schaltung bei Umschaltung in jedem Takt der Umwandlung des Eingangs- und Referenzsignales.

PATENTBESCHREIBUNG

Der Erfindung liegt die technische Aufgabe zugrunde, eine Einrichtung zur Wandlung der Leistung in Frequenz mit einem geringen relativen Fehler bei beliebiger Leistungsrichtung im Meßkreis zu entwickeln.

Die gestellte Aufgabe wird dadurch gelöst, daß in den Leistungsfrequenzwandler entsprechend der ersten Variante, der Eingangswandler für Strom und Spannung, deren Eingänge mit den entsprechenden Eingangsschienen und deren Ausgänge mit den Eingängen des ersten und zweiten Modulformers verbunden sind, einen Multiplikator, dessen Eingänge an die Ausgänge des ersten und zweiten Formermoduls angeschlossen und dessen Ausgang mit den Eingängen des ersten steuerbaren Inverters verbunden sind, einen Integrator, einen ersten und die zweiten Komparator, deren Ausgänge mit den Eingängen des ersten Logikelementes EXKLUSIVES ODER verbunden sind, enthält, ein Niederfrequenzfilter, ein zweiter steuerbarer Inverter, ein zweites und drittes Logikelement EXKLUSIVES ODER eingeführt werden, und der erste Komparator als Hysterese-Komparator ausgeführt wird und sein Ausgang den Frequenzausgang der Einrichtung bildet, wobei die zweiten Ausgänge des ersten und zweiten Modulformers entsprechend mit den ersten und zweiten Eingängen des zweiten Logikelements EXKLUSIVES ODER verbunden sind, dessen Ausgang an den ersten Eingang des dritten Logikelementes EXKLUSIVES ODER und den ersten Eingang des zweiten steuerbaren Inverters angeschlossen ist, dessen zweiter Eingang an den Ausgang des Multiplikators angeschlossen ist, und der Ausgang mit dem Niederfrequenzfilter verbunden ist, dessen Ausgang den Analogausgang der Einrichtung darstellt und mit dem Eingang des zweiten Komparators verbunden ist, dessen Ausgang den Polaritätsausgang der Einrichtung bildet, wobei der Ausgang des dritten Logikelements EXKLUSIVES ODER mit dem zweitem Eingang des ersten steuerbaren Inverters verbunden ist, dessen Ausgang an den Eingang des Integrators angeschlossen ist und dessen Ausgang mit dem Eingang des ersten Komparators verbunden ist, wobei der Ausgang des ersten Logikelementes EXKLUSIVES ODER mit dem zweiten Eingang des dritten Logikelementes EXKLUSIVES ODER verbunden ist.

Für den Wandler entsprechend der ersten Variante wird vorgeschlagen, den steuerbaren Inverter in Form eines logarithmischen Elementes, zweier Exponentialelemente, eines Inverters und einer NICHT-Schaltung auszuführen, wobei der Eingang des steuerbaren Inverters durch den Eingang des logarithmischen Elementes gebildet wird und sein Ausgang mit den ersten Eingängen der Exponentialelemente verbunden ist. Der Ausgang des ersten Exponentialelementes ist an den Eingang des Inverters angeschlossen, dessen Ausgang mit dem Ausgang des zweiten Exponentialelementes verbunden ist und den Ausgang des steuerbaren Invertors bildet. Die zweiten Eingänge des ersten und zweiten Exponentialelementes sind entsprechend an den Ausgang und den Eingang der NICHT-Schaltung angeschlossen, wobei letzterer den zweiten Eingang des steuerbaren Inverters darstellt.

Gemäß der zweiten Variante der Erfindung besteht das Neue der Erfindung in der Einführung eines Niederfrequenzfilters, eines zweiten und dritten Logikelementes EXKLUSIVES ODER, eines ersten, zweiten und dritten Exponentialelementes, einer NICHT-Schaltung, eines zweiten Inverters und der Ausführung des ersten Komparators als Hysterese-Komparator mit einem Ausgang, der den Frequenzausgang der Einrichtung bildet, wobei die zweiten Ausgänge des ersten und zweiten Modulformers entsprechend mit dem ersten und zweiten Eingang des zweiten Logikelementes EXKLUSIVES ODER verbunden sind, dessen Ausgang mit dem ersten Eingang des dritten Exponentialelementes und mit dem ersten Eingang des dritten Logikelementes EXKLUSIVES ODER verbunden ist, dessen Ausgang an den ersten Eingang des ersten Exponentialelementes und den Eingang der NICHT-Schaltung angeschlossen ist, deren Ausgang an den ersten Eingang des zweiten Exponentialelementes angeschlossen ist, dessen Ausgang mit dem Ausgang des ersten Inverters und mit dem Eingang des Integrators verbunden ist, dessen Ausgang mit dem Eingang des ersten Komparators verbunden ist, wobei der erste Ausgang des Multiplikators an die zweiten Eingänge des ersten, zweiten und dritten Exponentialelementes angeschlossen ist und der Ausgang des ersten Exponentialelementes mit dem Eingang des ersten Inverters verbunden ist, der zweite Ausgang des Multiplikators an den Ausgang des zweiten Inverters und den Eingang des Niederfrequenzfilters angeschlossen ist, dessen Ausgang den Analogausgang des Wandlers bildet und mit dem Eingang des zweiten Komparators verbunden ist, dessen Ausgang den Vorzeichenausgang der Einrichtung bildet, wobei der Ausgang des ersten Logikelementes EXKLUSIVES ODER mit dem zweiten Eingang des dritten Logikelementes EXKLUSIVES ODER verbunden ist.

Bei Verwirklichung der Erfindung entsprechend der zweiten Variante ist es zweckmäßig, den Multiplikator in Form von drei logarithmischen Elementen, eines Summators, eines Exponentialelementes und einer Referenzsignalquelle auszuführen, wobei der Eingang des ersten logarithmischen Elementes den ersten Eingang des Multiplikators bildet und sein Ausgang mit erstem Eingang des Summators verbunden ist, der Eingang des zweiten logarithmischen Elementes an den Ausgang der Referenzsignalquelle angeschlossen ist und deren Ausgang mit dem zweiten Eingang des Summators verbunden ist, der Eingang des dritten logarithmischen Elementes den zweiten Eingang des Multiplikators bildet und dessen Ausgang mit dem dritten Eingang des Summators verbunden ist, dessen Ausgang den ersten Ausgang des Multiplikators bildet und mit dem Eingang des Exponentialelementes verbunden ist, dessen Ausgang als zweiter Ausgang des Multiplikators dient.

In der ersten und zweiten Variante des Wandlers wird vorgeschlagen, das Exponentialelement in Form zweier bipolarer Transistoren mit gleichem Leitfähigkeitstyp und zweier Widerstände auszuführen, wobei der Emitter des ersten Transistors als Eingang und der Kollektor als Ausgang des Exponentialelementes dient, der Kollektor des zweiten Transistors mit der Basis des ersten Transistors und mit dem erstem Anschluß des ersten Widerstandes verbunden ist. Der erste Anschluß des zweiten Widerstandes ist an den Emitter des zweiten Transistors angeschlossen, dessen Basis mit der Nullpotentialschiene und dem zweitem Anschluß des ersten Widerstandes verbunden ist. Der zweite Anschluß des zweiten Widerstandes dient als zweiter Eingang des Exponentialelementes.

In beiden Varianten des Wandlers können die Inverter in Form zweier Transistoren, eines Verstärkers und eines Widerstandes ausgeführt sein. Der Kollektor des ersten Transistors ist mit dem Eingang des Verstärkers verbunden, dessen Ausgang ist durch einen Widerstand mit den Emittern der beiden Transistoren verbunden und die Basen der Transistoren sind an die Nullpotentialschiene angeschlossen. Der Kollektor des ersten Transistors bildet den Eingang und der Kollektor des zweiten Transistors den Ausgang des Inverters.

Die Vereinigung beider technischer Lösungen in einer Anmeldung ist damit verbunden, daß die beiden gegebenen Einrichtungen ein und dieselbe Aufgabe lösen - die Leistungswandlung mit geringem relativen Wandlungsfehler bei beliebiger Leistungsrichtung im Meßkreis auf prinzipiell gleichem Weg - aufgrund der Einführung eines Niederfrequenzfilters, zweier zusätzlicher Logikelemente EXKLUSIVES ODER, eines Inverters und ihrer Verbindungen mit den anderen Elementen der Schaltung und der Ausführung des Komparators als Hysterese-Komparator.

Das Wesen der Erfindung in jeder der Varianten ist gleichwertig, aber wesentliche Unterschiede können nicht durch verallgemeinernde Merkmale verbunden werden.

Der Wandler nach der ersten Variante setzt die Verwendung eines Analogmultiplikators mit einem Ausgangssignal in Form einer Gleichstromspannung voraus.

Der Wandler nach der zweiten Variante setzt die Verwendung eines logarithmischen Multiplikators voraus, der durch ein niedriges Niveau zusätzlicher Fehler im Ausgangssignal gekennzeichnet wird, was eine zusätzliche Verringerung des relativen Wandlungsfehlers gewährleistet. Dies erklärt sich durch eine Eigenschaft des logarithmischen Algorithmusses, nach der die zusätzlichen Fehler auf der Seite der Logarithmen (und das sind die auf den Ausgang der logarithmischen Elemente bezogenen Fehler, die auf den Eingang des Exponentialelementes bezogenen Fehler und die Summierungsfehler) auf die multiplikativen im Ergebnis der Multiplikation geführt werden. Der Stromcharakter des Signals an seinem zweiten Ausgang (Ausgangssignal des Exponentialelementes) erlaubt eine Verringerung des Einflusses des Fehlers des Potentialcharakters des Niederfrequenzfilters auf das Ergebnis der analogen Leistungswandlung und damit letztendlich auf die Richtigkeit der Bestimmung ihrer Richtung im Bereich kleiner Belastungen.

Der vorgeschlagene Wandler erlaubt in beiden Varianten die Gewährleistung der Arbeitsfähigkeit bei beliebiger der beiden möglichen Richtungen der mittleren Leistung im Meßkreis, während der bekannte Wandler diese funktionale Möglichkeit nicht aufweist, das heißt, der Arbeitsbereich hat sich mindestens verdoppelt.

Im Unterschied zur bekannten Einrichtung ist im vorgeschlagenen Wandler (seinen Varianten) die Empfindlichkeit des Wandlungsergebnisses (Frequenz des Ausgangsimpulssignales) gegenüber zusätzlichen Komponenten des Gerätefehlers des Integrators, bezogen auf seinen Eingang und hervorgerufen z.B. durch Parameter der Nichtidealität des Operationsverstärkers dieses Blockes, wesentlich kleiner, da bei der doppelten Integration des Nutzsignals (in Hin- und Rückrichtung) dieser Fehler dem Quadrat des Verhältnisses des Pegels des Arbeitssignals (Nutzsignals) zu den Rauschsignalen unabhängig vom Charakter (Potential- oder Stromcharakter) des Eingangssignals des Integrators proportional ist. Außerdem sind im vorgelegten Wandler periodische Abschaltungen der Eingangssignale zur Bildung der Hilfssignale (Referenzsignale) und entsprechende Informationsverluste ausgeschlossen, sowie auch begleitende Fehler, die durch die Nichtidealität der Verbindungselemente und die Trägheit des gesamten Signalumwandlungskanals hervorgerufen werden. Mögliche Quellen zusätzlicher Fehler in Form von Spannungen auf der Kapazität des Integrators oder Ansprechschwellen des Hysterese-Komparators wirken im Vergleich zu wertmäßig großen Pegeln der genannten Schwellen unabhängig vom Wert der zu messenden Belastungsleistung, daß heißt, sie zeigen sich im Frequenzausgangssignal in Form eines relativen Fehlers. Die Beseitigung der genannten additiven Fehler ermöglicht die Erweiterung des Bereiches der Leistungsfrequenzwandlung mit einer normierten Größe des relativen Fehlers bis 2-3 Dekaden (dezimale Größenordnungen) der Änderung der zu messenden Leistung, das heißt im Vergleich zum Prototyp eine Erhöhung von nicht weniger als 10 mal unter Beibehaltung der Arbeitsfähigkeit bei beliebiger Richtung der mittleren Leistung.

Die vorgeschlagene Ausführung im steuerbaren Inverter des Wandlers der ersten Variante und im Wandler der zweiten Variante des Exponentialelementes und des Inverters ermöglicht eine weitere Verringerung der Größe des relativen Wandlungsfehlers, da die Übertragung der Umschaltung auf die Seite der Logarithmen (Eingangskreis) des Exponentialelementes die Umwandlung des additiven Charakters der entsprechenden Fehler in einen multiplikativen am Ausgang dieses Elementes gewährleistet. Der Stromcharakter der Ausgangssignale der Exponentialelemente und der Inverter gewährleistet auch die Beseitigung der additiven Bestandteile des Fehlers der Frequenzwandlung und eine Verringerung für die Analogleistungswandlung, die durch Gerätefehler des Potentialcharakters entsprechend des Integrators und des Niederfrequenzfilters hervorrufen werden.

Kurze Beschreibung der Zeichnungen

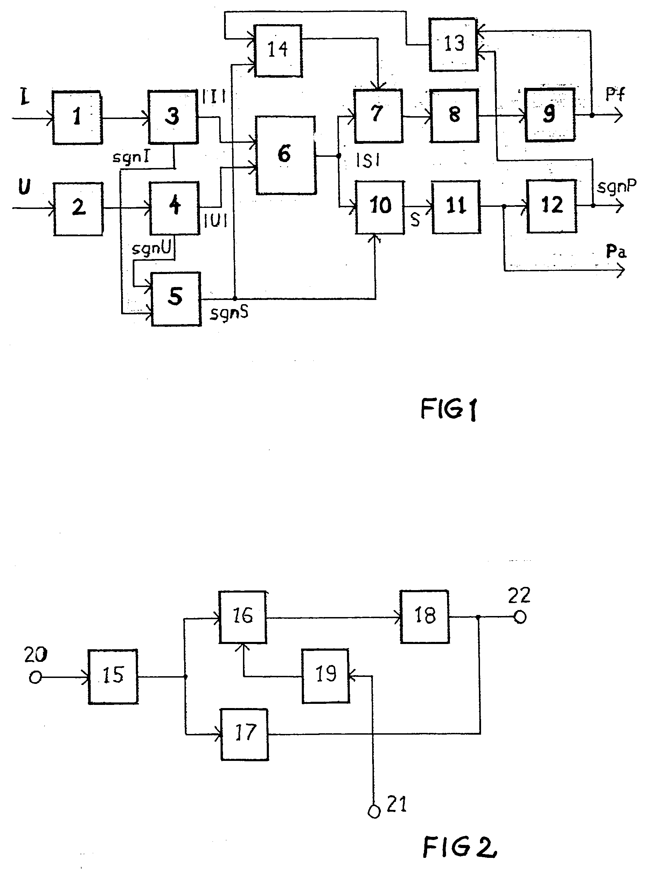

Auf Figur 1 ist das Funktionsschaltbild des Wandlers der ersten Variante dargestellt.

Auf Figur 2 ist die Schaltung der Realisierung des steuerbaren Inverters gezeigt, die in der ersten Variante des Wandlers Verwendung findet.

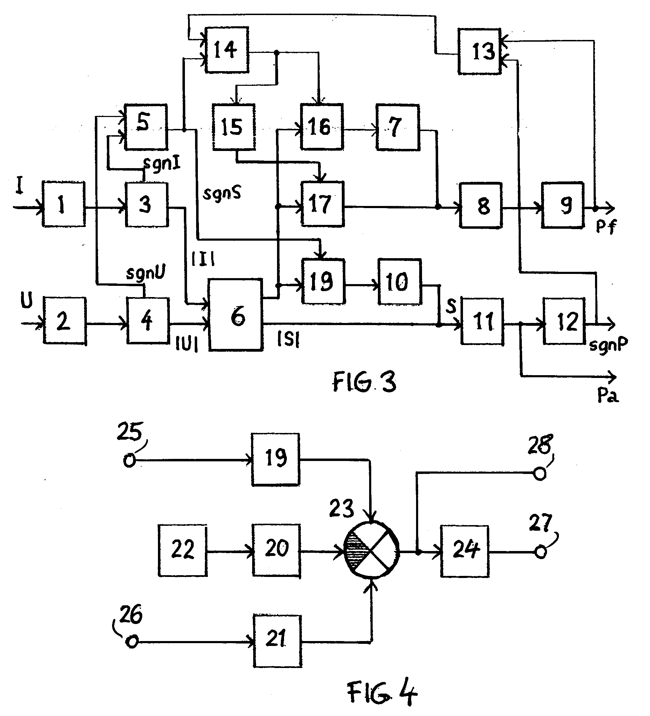

Auf Figur 3 ist das Funktionsschaltbild des Wandlers der zweiten Variante angeführt.

Auf Figur 4 ist die Schaltung zur Verwirklichung des Multiplikators für die zweite Variante des Wandlers vorgestellt.

Auf Bild 5 ist Schaltung des Exponentialelementes für die erste und zweite Variante des Wandlers angeführt.

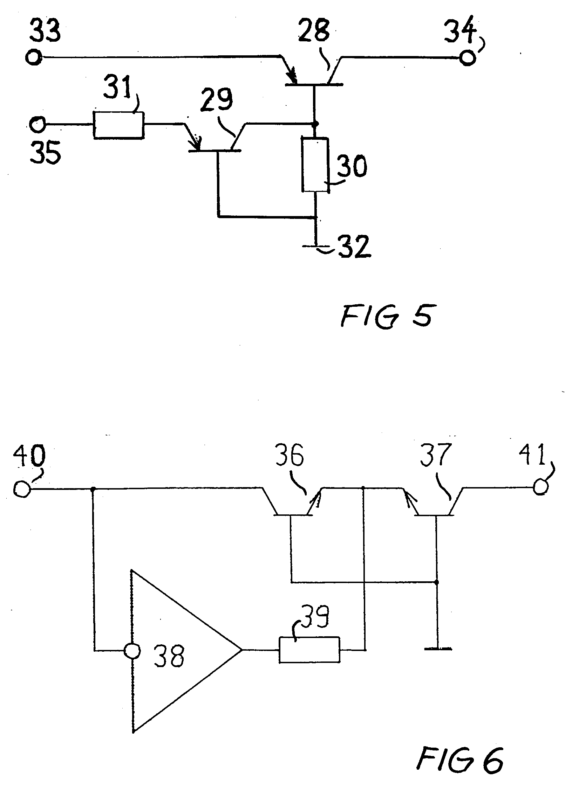

Auf Figur 6 ist ein Beispiel für Realisierung des Inverters für beiden Varianten des Wandlers dargestellt.

Die beste Variante der Erfindungsverwirklichung

Der Leistungsfrequenzwandler der ersten Variante (siehe Figur 1) enthält einen Eingangswandler 1 des Stromes und einen Eingangswandler 2 der Spannung, deren Eingänge die entsprechenden Eingangsschienen des Wandlers bilden, einen ersten Former 3 des Strommoduls und einen zweiten Former 4 des Spannungsmoduls, deren zweite Ausgänge mit den Eingängen des zweiten Logikelementes EXKLUSIVES ODER 5 und deren erste Ausgänge mit den Eingängen des Multiplikators 6 verbunden sind. Der Ausgang des Multiplikators 6 ist mit dem ersten Eingang des ersten steuerbaren Inverters 7 und sein Ausgang mit dem Eingang des Integrators 8 verbunden. Der Ausgang des Integrators 8 ist an den Eingang des ersten Komparators 9 angeschlossen. Der erste Eingang des zweiten steuerbaren Inverters 10 ist an den Ausgang des zweiten Logikelementes EXKLUSIVES ODER 5 und der zweite Eingang an den Ausgang des Multiplikators 6 angeschlossen. Der Ausgang des steuerbaren Inverters 10 ist an den Eingang des Niederfrequenzfilters 11 angeschlossen, dessen Ausgang mit dem Eingang des zweiten Komparators 12 verbunden ist. Die Eingänge des ersten Logikelementes EXKLUSIVES ODER 13 sind mit den Ausgängen des ersten und des zweiten Komparators 9 und 12 verbunden. Der erste Eingang des dritten Logikelementes EXKLUSIVES ODER 14 ist mit dem Ausgang des zweiten Logikelementes EXKLUSIVES ODER 5 verbunden, und der zweite Eingang - mit dem Ausgang des ersten Logikelementes EXKLUSIVES ODER 13. Der Ausgang des dritten Logikelementes EXKLUSIVES ODER 14 ist mit dem zweiten Eingang des ersten steuerbaren Inverters 7 verbunden.

Es wird vorgeschlagen, den steuerbaren Inverter des Wandlers der ersten Variante (siehe Figur 2) in Form des logarithmischen Elementes 15 auszuführen, dessen Ausgang mit den ersten Eingängen des ersten und zweiten Exponentialelementes 16 und 17 verbunden ist, deren Ausgänge entsprechend mit Eingang und Ausgang des Inverters 18 verbunden sind und deren zweite Eingänge entsprechend an Ausgang und Eingang der NICHT-Schaltung 19 angeschlossen sind. Der Eingang des logarithmischen Elementes 15 bildet den ersten Eingang 20 des steuerbaren Inverters, der zweite Eingang des zweiten Exponentialelementes 17 und der Eingang der NICHT-Schaltung 19 bilden den zweiten Eingang 21 des steuerbaren Inverters, als dessen Ausgang 22 die verbundenen Ausgänge des zweiten Exponentialelementes 17 und des Inverters 18 dienen.

Der Leistungsfrequenzwandler der zweiten Variante (siehe Figur 3) enthält den Eingangswandler des Stromes 1 und den Eingangswandler der Spannung 2, deren Eingänge die entsprechenden Eingangsschienen des Wandlers sind, den ersten Former 3 des Strommoduls und den zweiten Former 4 des Spannungsmoduls, deren zweite Ausgänge mit den Eingängen des zweiten Logikelementes EXKLUSIVES ODER 5 und deren erste Ausgänge mit dem ersten und zweiten Eingang des Multiplikators 6 verbunden sind. Der Ausgang des ersten Inverters 7 ist mit dem Eingang des Integrators 8 verbunden, dessen Ausgang mit dem Eingang des ersten Komparators 9 verbunden ist. Der zweite Ausgang des Multiplikators 6 ist an den zweiten Ausgang des zweiten Inverters 10 und den Eingang des Niederfrequenzfilters 11 angeschlossen, dessen Ausgang als Analogausgang des Wandlers dient und mit dem Eingang des zweiten Komparators 12 verbunden ist, dessen Ausgang den Vorzeichenausgang der Einrichtung bildet. Die Eingänge des ersten Logikelementes EXKLUSIVES ODER 13 sind mit den Ausgängen des ersten und zweiten Komparators 9 und 12 verbunden, und der Ausgang ist an zweiten Eingang des dritten Logikelementes EXKLUSIVES ODER 14 angeschlossen. Der Eingang der NICHT-Schaltung 15 ist an den ersten Eingang des ersten Exponentialelementes 16 und an den Ausgang des dritten Logikelementes EXKLUSIVES ODER 14 angeschlossen und der Ausgang ist mit dem ersten Eingang des zweiten Exponentialelementes 17 verbunden. Die zweiten Eingänge des ersten, zweiten und dritten Exponentialelementes 16, 17 und 18 sind mit dem ersten Ausgang des Multiplikators 6 verbunden. Der erste Eingang des dritten Logikelementes EXKLUSIVES ODER 14 ist mit dem Ausgang des zweiten Logikelementes EXKLUSIVES ODER 5 und dem ersten Eingang des dritten Exponentialelementes 18 verbunden, dessen Ausgang mit dem Eingang des zweiten Inverters 10 verbunden ist. Der Ausgang des ersten Exponentialelementes 16 ist mit dem Eingang des ersten Inverters 7 und der Ausgang des zweiten Exponentialelementes 17 mit dem Eingang des Integrators 8 verbunden.

Im Leistungswandler der zweiten Variante ist es zweckmäßig, den Multiplikator 6 in Form des ersten, zweiten und dritten logarithmischen Elementes 19, 20 und 21 (siehe Figur 4), der Quelle des Referenzsignals 22, deren Ausgang an den Eingang des zweiten logarithmischen Elementes 20 angeschlossen ist, auszuführen. Die drei Eingänge des Summators 23 sind entsprechend mit den Ausgängen des ersten, des zweiten und des dritten logarithmischen Elementes 19, 20 und 21 verbunden. Der Ausgang des Summators 23 ist mit dem Eingang des Exponentialelementes 24 verbunden und bildet den ersten Ausgang 28 des Multiplikators 6, als dessen zweiter Ausgang 27 der Ausgang des Exponentialelementes 24 dient. Der Eingang des ersten logarithmischen Elementes 19 bildet den ersten Eingang 25, und der Eingang des dritten logarithmischen Elementes 21 den zweiten Eingang 26 des Multiplikators 6.

Das Exponentialelement des Wandlers der ersten und zweiten Variante ist mittels des Transistors 29 (siehe Figur 5) ausgeführt. Für die Zustandsteuerung des Exponentialelementes dient der zweite Transistor 30 des gleichen Leitfähigkeitstyps, dessen Kollektor mit der Basis des ersten Transistors 29 und mit dem ersten Anschluß des ersten Widerstandes 30 verbunden ist. Der erste Anschluß des zweiten Widerstandes 32 ist an den Emitter des zweiten Transistors 30 angeschlossen, dessen Basis mit der Nullpotentialschiene 33 und dem zweiten Anschluß des ersten Widerstandes 31 verbunden ist. Der Emitter des ersten Transistors 29 bildet den Eingang 34 und der Kollektor den Ausgang 35 des Exponentialelementes. Der zweite Anschluß des zweiten Widerstandes 32 dient als Steuereingang 36 des Exponentialelementes.

Der Inverter 18 (siehe Figur 2) in der ersten Variante der Einrichtung, die Inverter 7 und 10 (Figur 3) in der zweiten Variante können als Strominverter (siehe Figur 6) auf der Grundlage eines Paares identischer Transistoren 37 und 38, deren Leitfähigkeitstyp dem Leitfähigkeitstyp der Transistoren der Exponentialelemente entgegengesetzt ist, ausgeführt werden. Der Kollektor des ersten Transistors 37 ist mit dem Eingang des Operationsverstärkers 39 verbunden, dessen Ausgang über Widerstand 40 mit den Emittern der Transistoren 37 und 38 verbunden ist, und die Basen der Transistoren sind an die Nullpotentialschiene angeschlossen. Der Kollektor des ersten Transistors 37 bildet den Eingang 41, und der Kollektor des zweiten Transistors 38 den Ausgang 42 des Inverters.

Der Leistungsfrequenzwandler der erster Variante arbeitet wie folgt. Die Eingangswandler des Stromes 1 und der Spannung 2 bringen die Primäreingangssignale - Strom I und Spannung U des elektrischen Meßkreises auf einen Pegel, der für die Arbeit des Rechenteiles optimal ist. Dieser enthält eine Vierquadrantenmultiplikationsschaltung, die auf der Basis eines mit Signalen einer Polarität arbeitenden Multiplikators 6 (siehe Figur 1) aufgebaut ist. Die Modulformer 3 und 4 bilden aus den bipolaren Ausgangssignalen der Eingangswandler des Stromes 1 und der Spannung 2 entsprechend I und U die Betragskomponenten |I| und |U| sowie die Polaritätskomponenten sgnI und sgn U. Die Betragskomponenten werden den Eingängen des Multiplikators 6 zugeführt, dessen Ausgangssignal |S| dem Produkt ihrer Momentanwerte proportional ist. Die Polaritätskomponenten sgnI und sgnU sind binäre Variablen, deren Werten sich bei Änderung der Polarität der entsprechenden Eingangssignale ändern. Sie gelangen an die Eingänge des zweiten Logikelementes EXKLUSIVES ODER 5, welches die Operation der Addition der logischen Eingangsvariablen nach Modul 2 so realisiert, daß sein binäres Ausgangssignal sgnS das Vorzeichen des Multiplikationsproduktes bestimmt und den Zustand des zweiten steuerbaren Inverters 10 steuert, wobei einer der Zustände dem Wiederholungsbetrieb und der zweite der Invertierung des Eingangsignales entspricht. Auf diese Weise erfolgt die Wiederherstellung des Vorzeichens des Produktes der Momentanwerte der Eingangssignale S an seinem Ausgang. Der Niederfrequenzfilter 11 verwirklicht seine zeitliche Mittelung, wobei die Zeitkonstante des Filters größer als die Periode der Grundschwingung der Eingangssignale gewählt wird, sodaß das Signal Pa an seinem Ausgang, das den Analogausgang des Wandlers darstellt, proportional der mittleren Leistung des Netzes ist und seine Polarität dem Vorzeichen (der Richtung) dieser Leistung eindeutig entspricht. Im Wechselstromnetz charakterisiert dieses Signal die Wirkleistung, das heißt, es berücksichtigt den Leistungsfaktor. Der Fixierung des Vorzeichens der Wirkleistung dient der zweite Komparator 12, sein binäres Ausgangssignal sgnP bildet den Polaritätsausgang des Wandlers und wird auch bei der Wandlung der Leistung in die Frequenz verwendet.

Der Momentanwert des Signals am Ausgang des ersten steuerbaren Inverters 7 ist ebenfalls dem Produkt der Momentanwerte der Ausgangssignale der Wandler 1 2 proportional, sein Vorzeichen entspricht oder widerspricht der Vorzeichenkomponente des Produktes sgnS (Ausgangssignal des Logikelements EXKLUSIVES ODER 5), die an einem Eingang des ersten Logikelementes EXKLUSIVES ODER 13 anliegt, in Abhängigkeit vom Steuersignal am anderen Eingang dieses Elementes. Bei einer von Null abweichenden Leistung im Meßkreis mit einer beliebigen Richtung vergrößert oder verkleinert sich in Abhängigkeit von der Polarität des Ausgangssignales des ersten steuerbaren Inverters 7 die Spannung am Ausgang des Integrators 8 und bestimmt einen der beiden möglichen Zustände des Hysterese-Komparators 9. Die Größe des Ausgangssignales dieses Elementes, die sich bei Erhöhung der Spannung am Ausgang des Integrators 8 und bei Erreichen des Wertes der oberen Schwelle einstellt, bleibt auch danach erhalten, und zwar sowohl bei größeren Werten dieser Spannung als auch bei ihrer Absenkung bis zur unteren Schwelle, wenn der Hysterese-Komparator 9 seinen zweiten Zustand einnimmt. Der zweite Zustand wiederum bleibt auch danach erhalten, und zwar sowohl bei Werten der Spannung am Ausgang des Integrators 8, die kleiner als die untere Schwelle sind als auch bei größeren, die aber nicht die obere Ansprechschwelle überschreiten. Der Zustand des ersten steuerbaren Inverters 7 und des Hysterese-Komparators 9 wird durch das erste und dritte Logikelement EXKLUSIVES ODER 13 und 14 so aufeinander abgestimmt, daß für eine beliebige der beiden möglichen Richtungen der mittleren Leistung im Meßkreis beim Erreichen der Spannung am Integrator 8 der oberen Ansprechschwelle des Hysterese-Komparators 9 sein geändertes Ausgangssignal den Zustand des ersten steuerbaren Inverters 7 umschaltet, was zur Absenkung der Spannung am Integrator 8 führt. Die Integrationskonstante des Integrators 8 wird so gewählt, das bei maximalem Lastpegel die Zeit zur Spannungsänderung an seinem Ausgang um einen Wert, der der Differenz zwischen oberer und unterer Ansprechschwelle des Hysterese-Komparators 9 (Breite der Hystereseschleife) gleich ist, größer ist als die Zeit zur Richtungsänderung der zu messenden Momentanleistung. Im Spezialfall der Energiemessung im Wechselstromnetz ist es ausreichend, diese Zeit größer als die Periode der (ersten) Grundschwingung auszuwählen. Bei der Einhaltung der genannten Bedingungen und bei unveränderter Richtung der mittleren Leistung im Meßkreiß gewährleistet die negative Rückkopplung, die durch die Verbindung des Ausgangs des Hysterese-Komparators 9 und des Steuereingangs des ersten steuerbaren Inverters 7 durch das erste und dritte Logikelement EXKLUSIVES ODER 13 und 14 realisiert wird, die Einhaltung der Spannung am Ausgang des Integrators 8 innerhalb eines Bereiches, der durch die obere und untere Ansprechschwelle des ersten Komparators 9 (der Breite der Hystereseschleife) begrenzt wird. Dabei ist die mittlere Frequenz des Impulssignales an seinem Ausgang Pf der im Meßkreis fließenden Leistung proportional, und er selbst dient als Frequenzausgang des Leistungswandlers. Der genannte Parameter im Wechselstromnetz charakterisiert die Wirkleistung, das heißt er berücksichtigt den Leistungsfaktor.

Bei Änderung der Leistungsrichtung im Meßkreis wird die genannte Bedingung verletzt. Für die Gewährleistung der Arbeitsfähigkeit des Wandlers wird in diesem Fall das geänderte Eingangssignal des zweiten Komparators 12 verwendet, das das erste Logikelement EXKLUSIVES ODER 13 in den Betrieb der Invertierung des Ausgangssignales des Hysterese-Komparators 9, welches am Eingang des dritten Logikelements EXKLUSIVES ODER 14 anliegt und damit die Erfüllung der Bedingung der negativen Rückkopplung der Umwandlung in die Frequenz bei beliebiger Richtung der Wirkleistung sichert, umschaltet. Dabei ist die mittlere Frequenz der Impulse Pf am Frequenzausgang des Wandlers proportional der im Meßkreis fließenden Leistung und hängt nicht von ihrer Richtung ab, Größe und Polarität der Spannung Pa am Analogausgang des Wandlers entsprechen eindeutig der Größe und Richtung dieser Leistung, und letzterer Parameter wird durch die logische Variable sgnP am Polaritätsausgang des Wandlers abgebildet.

Die steuerbaren Inverter 7 und 10 im Wandler der ersten Variante, die in Übereinstimmung mit Figur 2 ausgeführt sind, funktionieren folgendermaßen. Das Signal am Eingang 20 des Blocks 7 wird im logarithmischen Element 15 logarithmiert und danach einer Rückumwandlung mit Hilfe der einander identischen Exponentialelemente 16 und 17 (erstes und zweites Exponentialelement) unterzogen. Die Parameter der Elemente 15, 16 und 17 sind so aufeinander abgestimmt, daß die Ausgangssignale der Exponentialelemente 16 und 17 dem Eingangssignal des logarithmischen Elementes 15 proportional sind. Die Exponentialelemente 16 und 17 gestatten es, ihr Ausgangssignal zu schalten, das heißt, es bis auf eine vernachlässigbar kleine Größe bei einem Wert des Steuersignals, das dem Pegel der logischen Eins entspricht, zu verringern oder es mit einem Übertragungskoeffizienten gleich eins bei Nullpegel des Steuersignals an ihrem zweiten Eingang zu übertragen. Das Ausgangssignal des ersten Exponentialelementes 16 wird im Inverter 18 invertiert. Da die Ausgangssignale des Inverters 18 und des Exponentialelementes Stromcharakter aufweisen und die NICHT-Schaltung 19 den gegenphasigen Zustand der Exponentialelemente gewährleistet, hat der Gesamtausgangsstrom des Inverters 18 und des Exponentialelementes 17, der den Strom am Ausgang 22 des steuerbaren Inverters bildet, eine Richtung (Vorzeichen), die durch das Signal an seinem zweiten Eingang 21 bestimmt wird.

Als Modulformer mit zwei Ausgangssignalen - einem analogen und einem digitalen, die entsprechend die Betrags- und Vorzeichenkomponente des zweipoligen Eingangssignals bilden, ist die Verwendung von weithin bekannten aktiven Schaltungen zur Berechnung von Absolutwerten oder von Zweiweggleichrichtern des Typs "ideale Diode",die auf dem Schalten von gleichrichtenden Elementen (Dioden oder Transistoren) im Rückkopplungszweig der Operationsverstärker beruhen, möglich (siehe z.B. V.L. Schilo „Linejnye integralnye schemy v radioelektronnoi apparatyre", M., „Sovetskoye radio", 1979 g., s.183-188). Das Ausgangssignal einer solchen Schaltung entspricht der Betragskomponente des vorzeichenvariablen Eingangssignals. Die sprunghafte Änderung der Ausgangsspannung des Operationsverstärkers bei Änderung der Polarität des Eingangssignals mit einem Sprung von mehr als 1 V erlaubt seine Verwendung als Binärsignal, das eindeutig der Vorzeichenkomponente entspricht. Im Vergleich mit der möglichen Bestimmung des Vorzeichens der Eingangssignale mit Hilfe von Komparatoren, wie es in einer bekannten Einrichtung verwirklicht wurde, ist eine solche Realisierung zu bevorzugen, da sie es erlaubt, die Genauigkeit zu erhöhen und die Geräteaufwendungen zu verringern, besonders im Fall des Stromcharakters der Eingangssignale des Wandlers.

Für die richtige Arbeit der Einrichtung ist das Vorhandensein der Hysterese der Übertragungscharakteristik der Umwandlung im Hysterese-Komparator 9 notwendig. Die andere in der Literatur verwendete Bezeichnung für solche Elemente lautet regenerative Komparatoren, die mittels eines oder zweier Komparatoren bei obligatorischer Einführung von Elementen mit positiver Rückkopplung verwirklicht werden (siehe z.B. A.G. Aleksenko, E.A. Kolumbet, G.I. Starodub „Primeneniye prezisionnych analogovych mikroschem", M., „Radio i swyas", 1985, c. 180). Gut bekannt sind auch Verfahren zur Stabilisierung der Ansprechschwellen und der Breite der Hystereseschleife.

Der Leistungsfrequenzwandler der zweiten Variante (siehe Figur 2) arbeitet wie folgt. In ihm wird ein Einquadrantenmultiplikator 6 des Typs Logarithmus-Antilogarithmus eingesetzt, der mit einpoligen Eingangssignalen arbeitet und der ein logarithmisches und ein lineares Ausgangssignal (entsprechend am ersten und zweiten Ausgang) aufweist. Die Exponentialelemente 16, 17 und 18, die an den ersten (logarithmischen) Ausgang des Multiplikators angeschlossen sind, gestatten es, an seinem Ausgang einpolige Signale zu erhalten, die dem Ausgangssignal des Multiplikators proportional sind. Außerdem haben die Exponentialelemente 16, 17 und 18 Steuereingänge, die es gestatten, ihr Ausgangssignal zu schalten, das heißt, es auf eine vernachlässigbare Größe bei Werten des Steuersignals, die gleich dem Pegel der logischen Eins sind, zu verringern oder es mit einem Übertragungskoeffizienten gleich eins bei Nullpegel des Steuersignals zu übertragen. Wie auch in der Schaltung der ersten Variante der Einrichtung gemäß Figur 1 bildet das binäre Ausgangssignal des zweiten Logikelementes EXKLUSIVES ODER 5 sgnS die Vorzeichenkomponente des Ergebnisses des Produktes der Eingangsvariablen des Wandlers. Dieses Signal wird auf den steuerbaren Eingang des Exponentialelements 18 gelegt, dessen Ausgangssignal im Inverter 10 invertiert wird. Der Übertragungskoeffizient dieser in Reihe geschaltenen Elemente wird im offenen Zustand gleich zwei gewählt, womit die Gleichheit des Betrages und die Opposition des Vorzeichens des Gesamtausgangsstromes des Inverters 10 und des Multiplikators 6 für verschiedene Zustände des Exponentialelementes 18, das heißt, die Vierquadranten-Multiplikation im Kanal des Analogausgangsignals, gewährleistet wird. Analog wird die Vierquadranten-Multiplikation und die Steuerbarkeit des Vorzeichens des Eingangsignals am Integrator 8 im Kanal der Leistungsfrequenzwandlung gewährleistet. Das Ausgangssignal des dritten Logikelementes EXKLUSIVES ODER 14 und das ihm inverse Ausgangssignal der NICHT-Schaltung 15 werden an die steuerbaren Eingänge der einander identischen Exponentialelemente 16 und 17 so geleitet, daß sie sich immer im gegenphasigen Zustand befinden, daß heißt, das Ausgangsstromsignal eines von ihnen ist nahe null und das andere entspricht dem Signal an seinem Analogeingang, das heißt, es ist dem Produkt der Beträge der Eingangssignale proportional. Deshalb wird unter Berücksichtigung der Wirkung des ersten Inverters 7 der Gesamtausgangsstrom des Inverters 7 und des Exponentialelementes 17 zweipolig, abhängig vom Vorzeichen des Produktes der Momentanwerte der Eingangssignale S und des Signals der Rückkopplung nach der Frequenz.

In allem anderen ist die Wirkung der Wandlerschaltungen der ersten und zweiten Variante einander analog.

Die logarithmische Schaltung der Multiplikation, die im Wandler der zweiten Variante Verwendung findet, arbeitet wie folgt. Der Einquadrantenmultiplikator 6 (siehe Figur 4) beinhaltet die logarithmischen Elemente 19, 20 und 21, die die Logarithmierung der Betragskomponenten des Stromes |I| und der Spannung |U| und des Ausgangssignales Ir der Referenzstromquelle 22 realisieren. Ihre Ausgangssignale werden im Summator 23 addiert, wobei letzteres in die Summe mit entgegengesetztem Vorzeichen eingeht. Das Exponentialelement 24 bildet an seinem Ausgang ein einpoliges Stromsignal, das dem Exponenten des Summensignals gleich und dem Produkt der Betragskomponenten der Eingangssignale von Strom und Spannung |S| = |I| |U| / Ir proportional ist. Für die Realisierung des Exponentialelementes und der logarithmischen Elemente ist es zweckmäßig, einander identische bipolare Transistoren in Transdiodenschaltung zu verwenden (siehe z.B. Spravotschnik po nelinejnym schemam. Pod red. D. Schejngolda M., „Mir", 1977). In diesem Fall tragen die Ausgangssignale der logarithmischen Elemente Potentialcharakter (wie auch die Spannung am Emitterübergang des Transistors, der in der Rückkopplung des Operationsverstärkers eingeschlossen ist) und können in der Schaltung des logarithmischen Multiplikators sowohl mit Hilfe einer speziellen Additionsschaltung als auch auf dem Wege einer Reihenschaltung der Emitterübergänge addiert werden (siehe auch dort). Der Potentialcharakter des Summensignals ermöglicht den Anschluß einer beliebigen Anzahl von Exponentialelementen und den Erhalt einer entsprechenden Anzahl von Stromausgangssignalen, die dem Produkt der Eingangsvariablen proportional sind. Solch ein Summensignal wird als Ausgangssignal am ersten Ausgang des logarithmischen Multiplikators 6 verwendet.

Eine mögliche Modifikation der Auführung der zweiten Variante des Wandlers kann die Anwendung eines steuerbaren Exponentialelementes auch in der Schaltung des logarithmischen Multiplikators 6 sein. Die Steuerung seines Zustandes kann in diesem Fall, wie auch im Kanal der Leistungsfrequenzwandlung, gegenphasig mit einem ihm nach Parametern identischen Exponentialelement 18 vom Ausgangssignal des zweiten Logikelementes EXKLUSIVES ODER 5 durch eine zusätzlich eingeführte NICHT-Schaltung durchgeführt werden. In diesem Fall wird der Übertragungskoeffizient der in Reihe geschalteten Exponentialelement 18 und Inverter 10 im offenen Zustand auf eins eingestellt, womit die Vierquadranten-Multiplikation im Kanal des Analogausgangssignals gewährleistet wird.

Das Exponentialelement, das im steuerbaren Inverter der ersten und zweiten Variante des Wandlers zur Anwendung kommt, arbeitet wie folgt (siehe Figur 5). Die eigentlich nichtlineare Umwandlung realisiert der erste bipolare exponentielle Transistor 29, bei dem als funktionale Abhängigkeit die exponentielle Abhängigkeit des Kollektorstroms von der Spannung am Emitterübergang genutzt wird. Entsprechend dient der Emitter des exponentiellen Transistors 29 als Eingang 34 und der Kollektor als Ausgang 35 des Exponentialelementes. Die Steuerung des Zustandes des Exponentialelementes wird mit Hilfe eines anderen bipolaren Transistors 30 mit dem gleichen Typ der Leitfähigkeit realisiert. Bei niedrigem Spannungspegel am steuerbaren Eingang bezüglich der Nullpotentialschiene (bis 0,3 V für Siliziumtransistoren) ist der Kollektorstrom des Transistors 30 vernachlässigbar klein und erzeugt keine merkliche Spannung an der Basis des Exponentialtransistors 29 und beeinflußt deshalb seine Übertragungscharakteristik nicht, was dem offenen Zustand des Exponentialelementes entspricht. Die Größe des ersten Widerstandes 31 wird vergleichbar dem Durchgangswiderstand der Basis des Transistors gewählt, das heißt nicht größer als 200 Ω. Die Größe des zweiten Widerstandes 32 wird so gewählt, daß bei hohem Pegel des Signals am Steuereingang ein Spannungsabfall vom Kollektorstrom des zweiten Transistors 30 am ersten Widerstand in einer Größe von 200-250 mV entsteht, der den Kollektorstrom des ersten Transistors 29 unterbricht. Bei kleinem Spannungswert an der Ausgangsklemme des Exponentialelementes bezüglich der Nullpotentialschiene (Potentialerdung) enthält das Signal am Ausgang 35 in Form des Kollektorstromes des Transistors 29 praktisch keine zusätzlichen Fehler der Wandlung.

Die gleiche Eigenschaft weist auch die in Übereinstimmung mit Figur 6 vorgeschlagene Realisierung des Inverters auf. Aufgrund des großen Verstärkungskoeffizienten des Verstärkers 39 wird der Kollektorstrom des Transistors 37 in seinem Rückkopplungskreis gleich dem Eingangsstrom des Inverters gehalten. Die Gleichheit der Parameter und der Betriebsart der Transistoren 37 und 38 sichert die Proportionalität ihrer Kollektorströme in einem breiten Bereich und die gegensätzliche Ausrichtung des Eingangs- und des Ausgangsstromes des Inverters. Der Stromcharakter des Eingangs- und des Ausgangssignales sichert das Nichtvorhandensein von zusätzlichen Fehlern des Potentialcharakters im Ausgangssignal, zum Beispiel durch die Versatzspannung des Operationsverstärkers 39.

Gewerbliche Anwendbarkeit

Die vorliegende Erfindung kann man zum Aufbau von Meßleistungswandlern mit gleichzeitigem Erhalt des Ergebnisses in Form eines Frequenz- und eines Analogsignales wie auch in Elektroenergiezählern für Wechsel- und Gleichstrom verwenden. Für die Reproduktion der Einrichtung besteht keine Notwendigkeit für Elemente mit unbekannten Charakteristika und einzigartige Technologie. Der Aufbau kann mittels der weitverbreiteten Halbleiterelementebasis in diskreter oder integrierter Ausführung erfolgen.

**Patentansprüche**

1. Leistungsfrequenzwandler, der Eingangswandler für Strom und Spannung, deren Eingänge mit den entsprechenden Eingangsschienen und deren Ausgänge mit den Eingängen des ersten und des zweiten Modulformers verbunden sind, einen Multiplikator, dessen erster und zweiter Eingang entsprechend an die ersten Ausgänge des ersten und zweiten Modulformers angeschlossen sind und dessen Ausgang mit dem ersten Eingang des ersten steuerbaren Inverters verbunden ist, einen Integrator, einen ersten und zweiten Komparator, deren Ausgänge mit den Eingängen des ersten Logikelementes EXKLUSIVES ODER verbunden sind, enthält, gekennzeichnet dadurch, daß in ihn ein Niederfrequenzfilter, ein zweiter steuerbarer Inverter, ein zweites und drittes Logikelement EXKLUSIVES ODER eingeführt sind, und der erste Komparator als Hysterese-Komparator ausgeführt ist und sein Ausgang den Frequenzausgang der Einrichtung bildet, wobei die zweiten Ausgänge des ersten und zweiten Modulformers entsprechend mit dem ersten und zweiten Eingang des zweiten Logikelementes EXKLUSIVES ODER verbunden sind, dessen Ausgang an den ersten Eingang des dritten Logikelementes EXKLUSIVES ODER und an den zweiten Eingang des zweiten steuerbaren Inverters angeschlossen ist, dessen erster Eingang an den Ausgang des Multiplikators angeschlossen ist und der Ausgang mit dem Eingang des Niederfrequenzfilters verbunden ist, dessen Ausgang den Analogausgang der Einrichtung bildet und mit dem Eingang des zweiten Komparators verbunden ist, dessen Ausgang den Polaritätsausgang der Einrichtung bildet, wobei der Ausgang des dritten Logikelementes EXKLUSIVES ODER mit dem zweiten Eingang des ersten steuerbaren Inverters verbunden ist, dessen Ausgang an den Eingang des Integrators angeschlossen ist und sein Ausgang mit dem Eingang des ersten Komparators verbunden ist, wobei der Ausgang des ersten Logikelementes EXKLUSIVES ODER mit dem zweiten Eingang des dritten Logikelementes EXKLUSIVES ODER verbunden ist.

2. Leistungsfrequenzwandler nach Anspruch 1, gekennzeichnet dadurch, daß der steuerbare Inverter in Form eines logarithmischen Elementes, zweier Exponentialelemente, eines Inverters und einer NICHT-Schaltung ausgeführt ist, wobei den Eingang des steuerbaren Inverters der Eingang des logarithmischen Elementes bildet und sein Ausgang mit den ersten Eingängen der Exponentialelemente verbunden ist, der Ausgang des ersten Exponentialelementes an den Eingang des Inverters angeschlossen ist, dessen Ausgang mit dem Ausgang des zweiten Exponentialelementes verbunden ist und den Ausgang des steuerbaren Inverters bildet, die zweiten Eingänge des ersten und zweiten Exponentialelementes entsprechend an den Ausgang und den Eingang der NICHT-Schaltung angeschlossen sind, wobei letzterer den zweiten Eingang des steuerbaren Inverters darstellt.

3. Leistungsfrequenzwandler enthaltend Eingangswandler für Strom und Spannung, deren Eingänge mit den entsprechenden Eingangsschienen und deren Ausgänge mit den Eingängen des ersten und zweiten Modulformers verbunden sind, einen Multiplikator, dessen erster und zweiter Eingang entsprechend an die ersten Ausgänge des ersten und zweiten Modulformers angeschlossen sind, einen ersten Inverter, einen Integrator, einen ersten und zweiten Komparator, deren Ausgänge mit den Eingängen des ersten Logikelementes EXKLUSIVES ODER verbunden sind, gekennzeichnet dadurch, daß in ihn ein Niederfrequenzfilter, ein zweiter Inverter , ein zweites und drittes Logikelement EXKLUSIVES ODER, ein erstes, zweites und drittes Exponentialelement, eine NICHT-Schaltung eingeführt sind, und der erste Komparator als Hysterese-Komparator ausgeführt ist und sein Ausgang den Frequenzausgang der Einrichtung bildet, wobei die zweiten Ausgänge des ersten und zweiten Modulformers entsprechend mit den Eingängen des zweiten Logikelementes EXKLUSIVES ODER verbunden sind, dessen Ausgang an den ersten Eingang des dritten Logikelementes EXKLUSIVES ODER und den ersten Eingang des dritten Exponentialelementes angeschlossen ist, dessen zweiter Eingang an den ersten Ausgang des Multiplikators und an die zweiten Eingänge des ersten und zweiten Exponentialelementes angeschlossen ist, der Ausgang des ersten Exponentialelementes durch den ersten Inverter mit dem Eingang des Integrators und dem Ausgang des zweiten Exponentialelementes verbunden ist, der Ausgang des dritten Exponentialelementes durch den zweiten Inverter mit dem zweiten Ausgang des Multiplikators und dem Eingang des Niederfrequenzfilters verbunden ist, dessen Ausgang an den Eingang des zweiten Komparators angeschlossen ist und den Analogeingang des Wandlers bildet, der Ausgang des zweiten Komparators den Polaritätsausgang des Wandlers bildet, der Ausgang des Integrators mit dem Eingang des ersten Komparators verbunden ist, der Ausgang des ersten Logikelementes EXKLUSIVES ODER an den zweiten Eingang des dritten Logikelementes EXKLUSIVES ODER angeschlossen ist, dessen Ausgang mit dem ersten Eingang des ersten Exponentialelementes und durch die NICHT-Schaltung mit dem ersten Eingang des zweiten Exponentialelementes verbunden ist.

4. Leistungsfrequenzwandler nach Anspruch 3, gekennzeichnet dadurch, daß der Multiplikator in Form dreier logarithmischer Elemente, eines Summators, eines Exponentialelementes und einer Referenzsignalquelle ausgeführt ist, wobei der Eingang des ersten logarithmischen Elementes den ersten Eingang des Multiplikators bildet und sein Ausgang mit dem ersten Eingang des Summators verbunden ist, der Eingang des zweiten logarithmischen Elementes an den Ausgang der Referenzsignalquelle angeschlossen ist und sein Ausgang mit dem zweiten Eingang des Summators verbunden ist, der Eingang des dritten logarithmischen Elementes den zweiten Eingang des Multiplikators bildet und sein Ausgang mit dem dritten Eingang des Summators verbunden ist, dessen Ausgang den ersten Ausgang des Multiplikators bildet und mit dem Eingang des Exponentialelementes verbunden ist, dessen Ausgang als zweiter Ausgang des Multiplikators dient.

5. Leistungsfrequenzwandler nach den Ansprüchen 2 bis 4, gekennzeichnet dadurch, daß das Exponentialelement zwei Transistoren und zwei Widerstände enthält, wobei der Emitter des ersten Transistors als Eingang und der Kollektor als Ausgang des Exponentialelementes dient, der Kollektor des zweiten Transistors mit der Basis des ersten Transistors und dem ersten Anschluß des ersten Widerstandes verbunden ist, der erste Anschluß des zweiten Widerstandes an den Emitter des zweiten Transistors angeschlossen ist, dessen Basis mit der Nullpotentialschiene durch den ersten Widerstand verbunden ist, der zweite Anschluß des zweiten Widerstandes als zweiter Eingang des Exponentialelementes dient.

6. Leistungsfrequenzwandler nach den Ansprüchen 2 und 3, gekennzeichnet dadurch, daß der Inverter zwei Transistoren, einen Verstärker und einen Widerstand enthält, wobei der Kollektor des ersten Transistors mit dem Eingang des Verstärkers verbunden ist und den Eingang des Inverters bildet, der Ausgang des Verstärkers durch einen Widerstand mit den Emittern der Transistoren verbunden ist und die Basen der Transistoren an die Nullpotentialschiene angeschlossen sind, der Kollektor des zweiten Transistors den Ausgang des Inverters bildet.

FIG 1

FIG 2

FIG 3

FIG 4

FIG 5

FIG 6

| | International application No. |
|---|---|
| | PCT/RU93/00236 |

**A. CLASSIFICATION OF SUBJECT MATTER**

IPC$^5$      G01R 21/133

According to International Patent Classification (IPC) or to both national classification and IPC

**B. FIELDS SEARCHED**

Minimum documentation searched (classification system followed by classification symbols)

IPC$^5$      G01R 21/06, 21/133, 22/00

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO, A1, 83/03011 (SCIENTIFIC COLUMBUS, INC.), 1 September 1983 (01.09.83) | 1-2, 3-6 |
| A | FR, A1, 2616227 (NIBART OLIVIER), 9 December 1988 (09.12.88) | 1-2, 3-6 |

☐   Further documents are listed in the continuation of Box C.     ☐   See patent family annex.

| | |
|---|---|
| *   Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier document but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | |
| "O"   document referring to an oral disclosure, use, exhibition or other means | "Y"   document of particular relevance; the claimed invention cannot be considered to involve an inventive step when the document is combined with one or more other such documents, such combination being obvious to a person skilled in the art |
| "P"   document published prior to the international filing date but later than the priority date claimed | "&"   document member of the same patent family |

| Date of the actual completion of the international search | Date of mailing of the international search report |
|---|---|
| 1 March 1994 (01.03.94) | 4 March 1994 (01.04.94) |

| Name and mailing address of the ISA/ | Authorized officer |
|---|---|
| | |
| ISA/RU | |
| Facsimile No. | Telephone No. |

Form PCT/ISA/210 (second sheet) (July 1992)

International application No.

PCT/RU 93/00236

| C (Continuation). DOCUMENTS CONSIDERED TO BE RELEVANT | | |
|---|---|---|
| Category* | Citation of document, with indication, where appropriate, of the relevant passages | Relevant to claim No. |
| A | EP, A1, 91/03740 (KATRIB, Georgey), 21 March 1991 (21.03.91) | 1-2, 3-6 |
| A | EP, A1, 0265172 (THE GENERAL ELECTRIC COMPANY), 27 April 1988 (27.04.88) | 1-2, 3-6 |
| A | DE, A1, 3534085 (KAHMANN, Martin), 2 April 1987 (02.04.87) | 1-2, 3-6 |
| A | WO, A1, 86/03302 (CREST ENERGY SCAN LIMITED), 5 June 1986 (05.06.86) | 1-2, 3-6 |